# EUROPEAN PATENT APPLICATION

(11) **EP 4 481 422 A1**
(43) Date of publication of application: **25.12.2024**
(21) Application number: 23180858.5
(22) Date of filing: 22.06.2023
(51) Int. Cl.: G01R 33/54, G01R 33/24, G01R 33/28, G01R 33/36

(54) **MAGNETIC RESONANCE IMAGING SYSTEM MONITORING DEVICE**

(71) Applicant: Koninklijke Philips N.V., 5656 AG Eindhoven (NL)
(72) Inventor: FINDEKLEE, Christian, Eindhoven (NL); UHLEMANN, Falk, Eindhoven (NL); LEUSSLER, Christoph Günther, 5656AG Eindhoven (NL); LIPS, Oliver, Eindhoven (NL); SCHMIDT, Joachim Dieter, Eindhoven (NL); WANG, Xinyu, Eindhoven (NL); BORGERT, Joern, Eindhoven (NL); AMTHOR, Thomas Erik, Eindhoven (NL)
(74) Representative: Philips Intellectual Property & Standards

(57) **Abstract**

Disclosed herein is a medical system (100, 300, 500, 600) comprising a magnetic resonance imaging monitoring device (100). The magnetic resonance imaging monitoring device comprises: at least one antenna (102) configured for receiving radio-frequency transmissions from at least one magnetic resonance imaging system; a radio-frequency receiver (106) connected to the at least one antenna and configured for transforming the received radio-frequency transmissions into radio-frequency data; a memory (110) storing machine executable instructions (114); and a computational system (108). Execution of the machine executable instructions causes the computational system to continuously: control (200) the radio-frequency receiver to perform the transformation of the received radio-frequency transmissions into the radio-frequency data, determine (202) one or more operating states (122) of the at least one magnetic resonance imaging system using the radio-frequency data; and transmit (204) the one or more operating states via a network connection (604).

## Description

### FIELD OF THE INVENTION

The invention relates to magnetic resonance imaging, in particular to the remote control or monitoring of magnetic resonance imaging systems.

### BACKGROUND OF THE INVENTION

In magnetic resonance imaging (MRI) a static magnetic field, gradient magnetic fields, and radio-frequency (RF) are used, for example, to determine the concentration of nuclear spins of atoms (typically Hydrogen) within the body of a subject. Configuring and operating magnetic resonance imaging systems can be complicated and may require years of training.

United States patent application publication US2002113591A1 discloses a plurality of magnetic field induction coils and a radio-frequency (RF) detection coil are supported by a frame which is inserted into the bore of an MRI system to detect magnetic fields produced by gradient pulses and RF pulses produced during a scan. The detected magnetic fields are processed to produce gradient waveforms and RF pulse waveforms that are displayed to the user.

### SUMMARY OF THE INVENTION

The invention provides for a medical system, a computer program, and a method in the independent claims. Embodiments are given in the dependent claims.

As was mentioned above, operating a magnetic resonance imaging system may require experience and training. In recent years there has been a desire to operate or control magnetic resonance imaging systems remotely. A challenge to this is that a clinical site or hospital may have magnetic resonance imaging systems from different manufacturers or even older systems not currently supported by the original manufacturer. As a result, it may not be possible to modify the software running the magnetic resonance imaging system to enable remote control. A way around this is capture the screen images intended for a local operator and provide a remote user interface. The remote user interface may for example be a mouse and/or keyboard device that can be controlled remotely, i.e., via the internet. This goes a long way in enabling remote control of magnetic resonance imaging systems, however the active state of the magnetic resonance imaging system may be unknown and not accessible via such a remote interface.

Embodiments may provide a means determining the operational state of one or more magnetic resonance imaging systems by measuring their radio-frequency transmissions. This works even outside of the radio-frequency shield of an individual magnetic resonance imaging system. A radio-frequency receiver can be used to measure radio-frequency data which may then be used to determine an operational state of one or more magnetic resonance imaging systems.

In one aspect the invention provides for a medical system that comprises a magnetic resonance imaging monitoring device. The magnetic resonance imaging monitoring device comprises at least one antenna that is configured for receiving radio-frequency transmissions from at least one magnetic resonance imaging system. The magnetic resonance imaging monitoring device further comprises a radio-frequency receiver connected to the at least one antenna and configured for transforming the received radio-frequency transmission into radio-frequency data.

The magnetic resonance imaging monitoring device further comprises a memory storing machine-executable instructions and a computational system. Execution of the machine-executable instructions causes the computational system to continuously control the receiver to perform the transformation of the received radio-frequency transmissions into the radio-frequency data. Execution of the machine-executable instructions further causes the computational system to continuously determine one or more operating states of the at least one magnetic resonance imaging system using the radio-frequency data. Execution of the machine-executable instructions further causes the computational system to continuously transmit the one or more operating states via the network connection.

In another aspect the invention provides for a computer program comprising machine-executable instructions for execution by a computational system controlling the magnetic resonance imaging monitoring device. The magnetic resonance imaging monitoring device comprises at least one antenna configured for receiving radio-frequency transmissions from at least one magnetic resonance imaging system. The magnetic resonance imaging monitoring device further comprises a radio-frequency receiver connected to the at least one antenna and configured for transforming the received radio-frequency transmissions into radio-frequency data.

Execution of the machine-executable instructions causes the computational system to continuously control the receiver to perform the transformation of the received radio-frequency transmissions into the radio-frequency data. Execution of the machine-executable instructions further causes the computational system to continuously determine one or more operating states of the at least one magnetic resonance imaging system using the radio-frequency data. Execution of the machine-executable instructions further causes the computational system to continuously transmit the one or more operating states via the network connection.

In another aspect the invention provides for a method of operating a medical system. The medical system comprises a magnetic resonance imaging monitoring device. The magnetic resonance imaging monitoring device comprises at least one antenna that is configured for receiving radio-frequency transmissions from at least one magnetic resonance imaging system. The medical system further comprises a radio-frequency receiver connected to the at least one antenna and configured for transforming the received radio-frequency transmissions into radio-frequency data. The method comprises repeatedly or continuously controlling the receiver to perform the transmission of the received radio-frequency transmissions into the radio-frequency data. The method further comprises continuously determining the one or more operating states of the at least one magnetic resonance imaging system using the radio-frequency data. The method further comprises continuously transmitting the one or more operating states via a network connection.

### BRIEF DESCRIPTION OF THE DRAWINGS

In the following preferred embodiments of the invention will be described, by way of example only, and with reference to the drawings in which:
Fig. 1 illustrates an example of a medical system.
Fig. 2 shows a flow chart which illustrates a method of using the medical system of Fig. 1.
Fig. 3 shows several charts which illustrate the processing of the radio-frequency data.
Fig. 4 illustrates a software defined radio.
Fig. 5 illustrates a further example of a medical system.
Fig. 6 illustrates a further example of a medical system.

### DETAILED DESCRIPTION OF EMBODIMENTS

Like numbered elements in these figures are either equivalent elements or perform the same function. Elements which have been discussed previously will not necessarily be discussed in later figures if the function is equivalent.

Examples may be beneficial because it may provide for a means of determining if a magnetic resonance imaging system is operating and, in some cases what sort of operations the magnetic resonance imaging system is performing without having direct access to the controller of the magnetic resonance imaging system.

In hospitals or other medical facilities, it is possible to have magnetic resonance imaging systems from more than one vendor or manufacturer. The difficulty with this is that there may not be direct software access or a software interface which may enable the determination of the state of the magnetic resonance imaging system directly. The magnetic resonance imaging monitoring device is able to measure the radio-frequency transmissions from the at least one magnetic resonance imaging system and from these infer the operating state. Further, many different vendors although they may have the same nominal field strength, tend to operate at slightly different frequencies. This may enable the distinguishing between different magnetic resonance imaging systems.

Often times magnetic resonance imaging systems will be located within a radio-frequency shield or screen. However, the magnetic resonance imaging systems produce so much radio-frequency energy that the antenna may for example be placed outside of the radio-frequency screens and still detect the operation of the magnetic resonance imaging system. Often only one or several of the magnetic resonance imaging monitoring devices would be necessary for monitoring an entire facility.

In some examples, the transmission of the one or more operating states via a network connection is simply a transmission of the change in the operating state of the magnetic resonance imaging system. For example, if the magnetic resonance imaging system is determined to be operational then it becomes operational and then ceases to operate, the change in the operating state could be transmitted.

Several variations of this system may exist. In one example the computational system and the radio-frequency receiver are housed together as a common component. In this case, for example, it may be a box or device which is placed in the medical facility and then connected, for example, using a local area network to transmit the one or more operating states. In other examples the radio-frequency receiver may provide the data remotely to the computational system, which then performs the analysis to determine the one or more operating states, which then provides or transmits the one or more operating states.

In some instances, the radio-frequency receiver may function completely digitally and digitize the received radio-frequency transmissions into the radio-frequency data. In other cases, analog circuitry may be used to provide such things as power measurements at specific frequencies corresponding to the Larmor frequency of a particular MR system. So, there are a variety of ways of constructing the medical system as well as configuring the radio-frequency receiver.

In another example, the medical system further comprises the one or more magnetic resonance imaging systems. This may be beneficial because it may provide a means of monitoring the one or more magnetic resonance imaging systems. Typically, the antenna or antennas may be placed within the same building as the magnetic resonance imaging systems. In some other examples the antenna may be placed within 100 meters if magnetic resonance imaging systems which are to be examined.

In another example, the one or more magnetic resonance imaging systems comprises a radio-frequency cage. At least a portion of the at least one antenna is located outside of the radio-frequency cage. This may be beneficial because the magnetic resonance imaging monitoring device may be placed away from the magnetic resonance imaging systems. In some examples, the one or more antennas may be placed within the radio-frequency cage, however, the functioning of the device is not dependent upon the at least one antenna being placed within the radio-frequency cage.

In another example, the at least one of the one or more magnetic resonance imaging systems comprises a radio-frequency component connected to a radio-frequency transmitter via a transmission line. At least one of the at least one antenna is located within a predetermined distance to the radio-frequency component. The radio-frequency data is descriptive of the operation of the radio-frequency transmitter. The one or more operating states comprise an operational state of the radio-frequency transmitter. This may be beneficial because when the antenna is placed adjacent or near the radio-frequency component or the transmission line it may be able to detect small amounts of leakage of the radio-frequency energy and detect the operational state of the radio-frequency transmitter. The radio-frequency component could for example be a body coil, a magnetic resonance imaging coil, a radio-frequency connector of the transmission line, or a radio-frequency connector connecting the radio-frequency transmitter to the transmission line, at least a portion of the radio-frequency transmitter itself, or any component along the signal path to the transmit coil.

In another example, the at least one of the one or more magnetic resonance imaging systems comprises a body coil connected to a radio-frequency transmitter via a body coil radio-frequency cable. At least one of the at least one antenna is located within a predetermined distance to the body coil. The radio-frequency data is descriptive of the operation of the radio-frequency transmitter. The one or more operating states comprise an operational state of the radio-frequency transmitter. This may be beneficial because when the antenna is placed adjacent or near the body coil radio-frequency cable it may be able to detect small amounts of leakage of the radio-frequency energy and detect the operational state of the radio-frequency transmitter.

In some examples with the radio frequency component or the body coil the predetermined distance could be less than 5 meters. In other examples with the radio frequency component or the body coil the predetermined distance could be less than 1 meter.

In other examples with the radio frequency component or the body coil the predetermined distance could be less than 50 cm.

In another example the radio-frequency receiver is configured for measuring the radio-frequency data as one or more analog measurements. For example, there may be one or more filter or passive components which could be used to provide radio-frequency data or an amplitude at particular frequencies corresponding to the Larmor frequency of different magnetic resonance imaging systems. This could for example be implemented as an antenna with a preamp and a rectifier. If the signal for example reached a predetermined threshold, then one could assume that the magnetic resonance imaging system is operating.

This may have the benefit that it may provide an extremely simple and inexpensive means of detecting if a magnetic resonance imaging system is operating.

In another example the radio-frequency receiver is configured for digitizing the received radio-frequency transmission into the radio-frequency data. This may be beneficial because digital signal processing techniques may be used to perform a more complex analysis of the radio-frequency data. This may for example enable the complex detection of different states of multiple magnetic resonance imaging systems.

In another example execution of the machine-executable instructions further causes the computational system to determine a frequency spectrum inside of a magnetic resonance system-specific central frequency at a magnetic field isocenter of the at least one magnetic resonance imaging system and to determine an in-operation state or a not-in-operation state for the at least one magnetic resonance imaging system using the frequency spectrum inside of the magnetic resonance system-specific central frequency. The one or more operating states comprise the in-operation state and the not-in-operation state.

Magnetic resonance imaging systems have a main magnetic field. To perform magnetic resonance imaging there is a region within the isocenter of the magnet where it is desired to have the magnetic field as uniform as possible. The area, which is defined as having the uniform field, corresponds to a Larmor frequency of hydrogen atoms in this field. This is the central frequency. The exact magnetic field of different magnetic resonance imaging systems may vary slightly. This enables the differentiation between different magnetic resonance imaging systems by having different magnetic resonance system-specific central frequencies. The example is beneficial because it may provide for a means of determining if multiple magnetic resonance imaging systems are operating or not operating using a single antenna.

In another example execution of the machine-executable instructions further causes the computational system to determine any one of the following: a radio-frequency amplitude, a radio-frequency bandwidth, a radio-frequency pulse duration, and combinations thereof using the radio-frequency data. Execution of the machine-executable instructions further causes the computational system to determine a pulse sequence protocol by comparing any one of the following: the radio-frequency amplitude, the radio-frequency bandwidth, the radio-frequency pulse duration and combinations thereof to a database of pulse sequences. The one or more operating states comprise the pulse sequence protocol. By looking at a catalog of one or more of these different radio-frequency properties which can be derived from the radio-frequency data can be constructed to provide a precise definition of the operating state of a particular magnetic resonance imaging system.

The data for the database of pulse sequences may be constructed in several different ways. A knowledge of the design of the magnetic resonance imaging system and a particular pulse frequency allows any of this data to be calculated. An alternative to this would be to make sure that only one magnetic resonance imaging system is operating and then to measure these properties during operation of this magnetic resonance imaging system. For example, the magnetic resonance imaging system can be run through a number of standard MR protocols for that particular magnetic resonance imaging system and these different quantities can be calculated and then stored in this database of pulse sequences. In either case it is relatively straightforward to calculate or measure the database of pulse sequences.

In another example execution of the machine-executable instructions further causes the computational system to detect a failure mode by comparing any one of the following: the radio-frequency amplitude, the radio-frequency bandwidth, the radio-frequency pulse duration and combinations thereof to the database of pulse sequences. Execution of the machine-executable instructions further causes the computational system to send a warning signal via the network connection if the failure mode is detected. This failure mode could be for example detected in several different ways. The values of these particular radio-frequency properties derived from the radio-frequency data could also be stored in the database of pulse sequences and this could be used to trigger a particular alarm or signal. In another example, if a match in the database of pulse sequences is not found then this may also be used to trigger sending the warning signal.

In some examples the warning signal is one of the one or more operating states that are transmitted via the network connection. In other examples, the warning signal could be a separate signal that is provided. For example, it may be a separate signal used to indicate that one or more magnetic resonance imaging systems are not functioning properly.

In another example, the at least one antenna is multiple antennas. The radio-frequency data is acquired for the multiple antennas. The radio-frequency data for the multiple antennas is phase and/or amplitude correlated. Execution of the machine-executable instructions further causes the computational system to determine a direction of the radio-frequency transmission using the phase and/or amplitude correlation of the radio-frequency data. Execution of the machine-executable instructions further causes the computational system to differentiate the different at least one magnetic resonance imaging system using the direction of the radio-frequency transmission. Execution of the machine-executable instructions further causes the computational system to modify the one or more operating states to indicate which of the at least one magnetic resonance imaging system is operational using the direction of the radio-frequency transmissions. This example may for example be beneficial because it may provide for differentiating a number of magnetic resonance imaging systems which have similar radio-frequency transmissions during use. It may also add more confidence to the accuracy of the one or more operating states which is transmitted via the network connection.

In another example, execution of the machine-executable instructions further causes the computational system to time stamp the one or more operating states before transmission. This may for example be very useful in the situation where the magnetic resonance imaging systems are being controlled remotely. The time stamp may for example enable the one or more operating states to be correlated with a controller and may assist in the automated control of the magnetic resonance imaging systems.

In another example the medical system further comprises a remote-control system configured for simultaneously controlling the one or more magnetic resonance imaging systems. The remote-control system is configured for receiving the one or more operating states via the network connection. This may be beneficial because the operating states may be useful in several different situations. For example, if a user interface is provided to an operator the operating states may assist the remote operator in determining if the magnetic resonance imaging systems are functioning as they should. This may also be useful in an automated control situation. For example, software robots or scripts may take the one or more operating states of the at least one magnetic resonance imaging system and use these in their control algorithm.

Remote-control systems exist for magnetic resonance imaging systems. One way of performing this currently is to have a screen capture of the screen provided by the computer running the magnetic resonance imaging system and plugging a USB device into the computer to enable remote-control of the computer actually controlling the magnetic resonance imaging system. This may be useful when there is no direct software access to the magnetic resonance imaging systems. The combination of capturing the screen and using the USB controller enables either a person or a software robot to control the magnetic resonance imaging system as if they were sitting in the control room.

In another example the remote-control system is configured to detect an early halt in a magnetic resonance imaging procedure in a detected magnetic resonance imaging system of the at least one magnetic resonance imaging system using the one or more operating states via the network connection and then to send failure recovery control commands to the detected magnetic resonance imaging system in response to detecting the early halt. This may be beneficial because when the magnetic resonance imaging systems are being operated remotely the software robot may have for example, no knowledge if the magnetic resonance imaging system is actually functioning as intended. If the early halt is detected then the medical system can for example, have a controller which sends commands to shut off the magnetic resonance imaging system for safety reasons and/or to send these failure recovery control commands to try to recover or reacquire the data which was not acquired.

In another example the early halt in the magnetic resonance imaging procedure can be used to trigger a magnetic resonance imaging system-specific warning on a remote display. For example, this may cause a window or message to pop-up to indicate that a particular magnetic resonance imaging system is not functioning properly.

In another example the remote-control system is configured to generate scheduling data for at least one magnetic resonance imaging procedure using the at least one magnetic resonance imaging system using the one or more operating states. The remote-control system is further configured to control a timing of control commands sent to the at least one magnetic resonance imaging system using the scheduling data. In a data control loop formed by the remote-control system, the one or more magnetic resonance imaging systems, and the magnetic resonance imaging monitoring device the magnetic resonance imaging monitoring device is used to provide feedback. The scheduling data may include such things as when to send automated controls to the magnetic resonance imaging system as well as providing detailed instructions for operators.

In another example the remote-control system is configured to display one or more operating states on a remote display.

In another example the remote-control system is configured to display a control screen for the at least one magnetic resonance imaging system on the remote display.

In another example the remote-control system is configured to adjust a focus of which control scheme for at least one magnetic resonance imaging system is displayed on the control screen using the one or more operating states. These examples may be beneficial because they may provide for an automated means of altering or updating the remote displays.

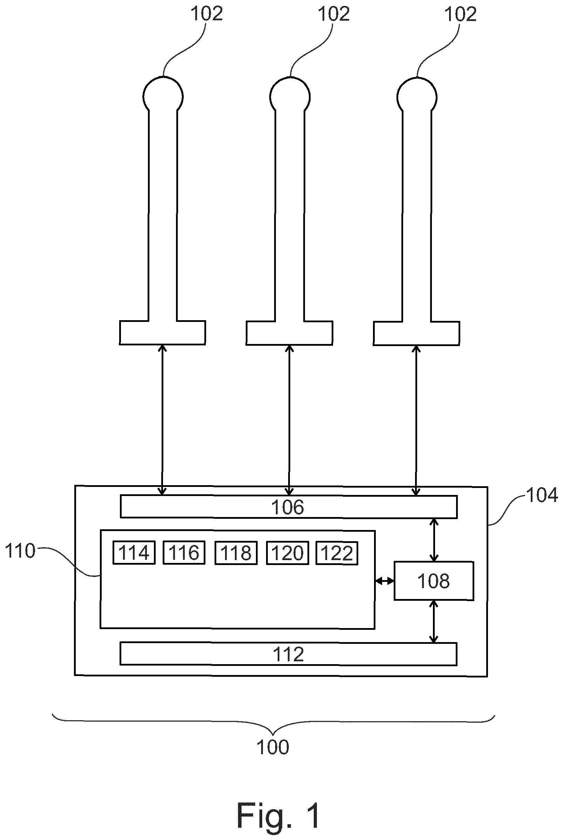

Fig. 1 illustrates an example of a medical system 100. In this example the medical system 100 is shown as having multiple antennas 102 connected to a radio-frequency receiver 106 that is integrated into a computer 104. In other examples there may also be a single antenna or other numbers than three antennas 102. The computer 104 is further shown as containing a computational system 108 that is in communication with the radio-frequency receiver 106. The computational system 108 is shown as being in further contact or communication with a memory 110 and a network interface 112.

The memory 110 is shown as containing machine-executable instructions 114 that enable the computational system 104 to control the various components of the medical system 100 as well as perform various numerical and computational tasks. The memory 110 is further shown as containing radio-frequency data 116 that has been acquired by the radio-frequency receiver 106 using one or more antennas 102. The memory 110 is further shown as containing a radio-frequency parameter 118 that has been calculated from the radio-frequency data 116. The radio-frequency parameter 118 may include such things as a radio-frequency amplitude, a radio-frequency bandwidth, a radio-frequency pulse duration that has been calculated from the radio-frequency data 116. In another example the radio-frequency parameter 118 may be a frequency spectrum that is determined inside of the magnetic resonance system-specific central frequency for at least one magnetic resonance imaging system. The radio-frequency parameters 118 may be optionally compared to a database of pulse sequences 120 to determine for example the identity of a pulse sequence protocol or to detect a failure mode. The memory 110 is further shown as containing an operating state 122 of one or more magnetic resonance imaging systems that has been determined using the radio-frequency data 116 and/or the radio-frequency parameter 118.

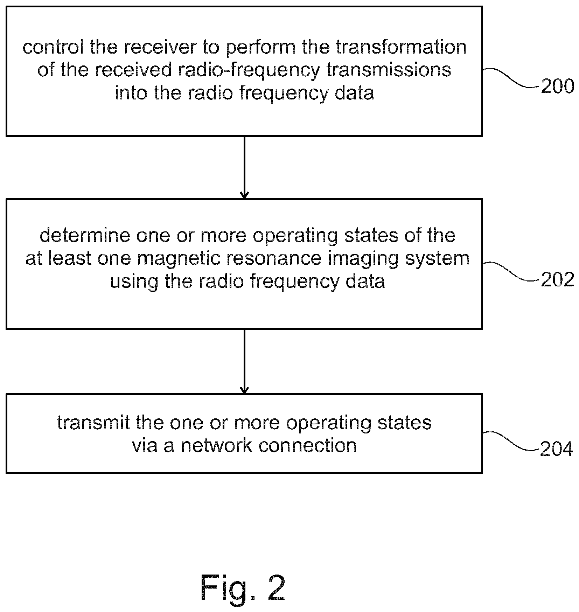

Fig. 2 shows a flowchart which illustrates a method of operating the medical system 100 of Fig. 1. In step 200 the radio-frequency receiver 106 is controlled to perform the transformation of the received radio-frequency transmissions into the radio-frequency data 116. Next, in step 202, one or more operating states 122 are determined of the at least one magnetic resonance imaging system using the radio-frequency data 116. Then in step 204 the one or more operating states 122 is transmitted via the network connection which is formed by the network interface 112. The process illustrated in steps 200, 202 and 204 may be repeated.

As was mentioned above, radiologic procedures and services are becoming increasingly distributed and virtualized. The importance for remote operation and reading services has been clearly seen in the current Covid-19 pandemic. All staff and all automated support technology need to be aware of the status of running processes, in particular imaging examinations, in real time in order to organize and predict their next tasks.

For such workflow analyses and optimization, exact timestamps of diverse events may be beneficial. In recent years, we have already been using logfile data in post-processing but also in real-time to derive such timestamps especially in applications like medical imaging. With this, we get very reliable and actual data e.g. in MRI or CT procedures.

Examples may provide for an inexpensive and advanced RF detector to detect the operation and further sequence details of MRI scans from a large distance.

Traditional sensors watching the system state are expensive and demand close access to those systems. Transmitting sensor information to any evaluation/processing/storage system can also be challenging in a clinical environment. Often there are several systems to be analyzed at the same time, e.g. a set of different MRI scanners in a radiology department. A system detecting scan operation without further access to the systems would be very beneficial then.

A comprehensive such system would also be able to monitor MRI systems of all vendors within the covered detectability range. This is required to enable virtualization and process control in every real clinical setting or in larger radiologic centers. A single imaging system provider, such as Philips, has no access to the other vendors' devices and real-time device status.

Examples may overcome this problem by proposing an advanced, yet cheap, RF sensor that is suitable to be used in an arbitrary radiology setup without direct access to the MRI systems, a method to process the received data/spectra and create status information for diverse scanners simultaneously.

Specifically, examples may detect and characterizes RF radiation of MRI systems, may add timing data to it, and analyzes the signal in order to determine the scan type of an MRI system such as survey scan, normal scan, etc.

Examples may use the RF radiation generated by MRI systems, which can be done even through walls and at distances of 10-100m. By evaluating signal amplitude and frequency, we can distinguish different system types with low effort. By using two or more correlated antennas, we can further get information of the geometrical direction to distinguish even identical signals from similar MRI scanners.

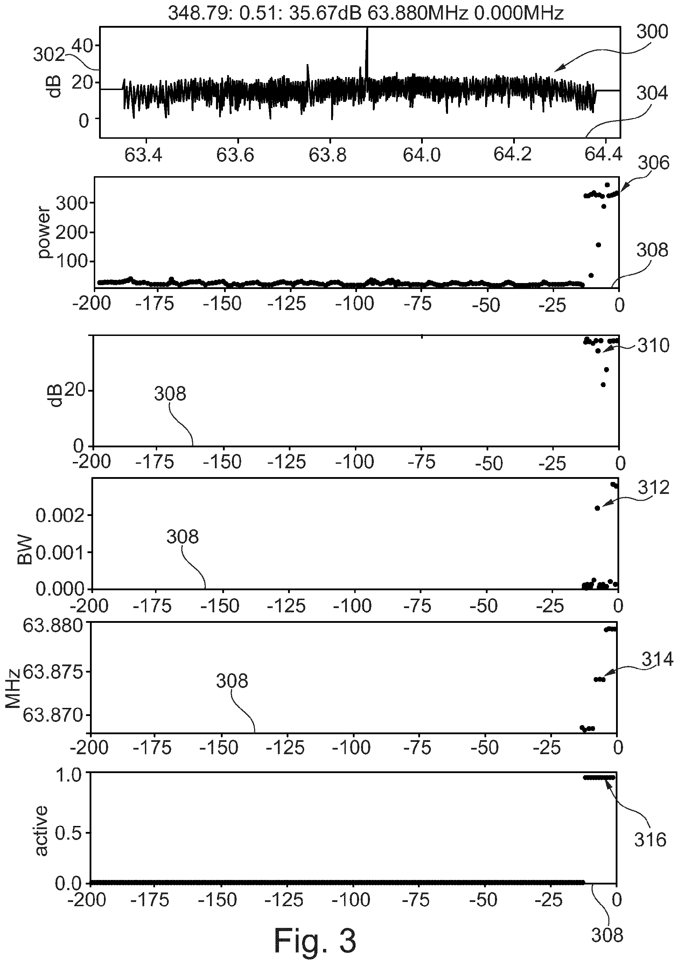

Fig. 3 illustrates several different plots. Top there is a plot of the spectrum 300 plotted in terms of dB 302 and time or samples 304. This could be an example of a power or frequency spectrum calculated from the radio-frequency data 116. In the chart below this, there is a chart of power 306 as a function of time 308. Below this there is a plot of the noise 310 as a function of time. Below this there is a chart of the bandwidth 312 as a function of time or samples 308. The next chart shows the central (Lamar) frequency measured 314 as a function of time or samples 308. The chart at the bottom 316 is an in use or active indicator calculated from the other values in the charts above it as a function of time or samples 308. The values 316 would for example be an operating status 122.

For the measurements in Fig. 3, an inexpensive Software Defined Radio (SDR) was used. There are many very basic implementations available (often based on very inexpensive RTL R820T2 and Realtec RTL2832U chips, originally designed for DAB and DVB-T receivers. This offers a general-purpose digital receiver for a large frequency band.

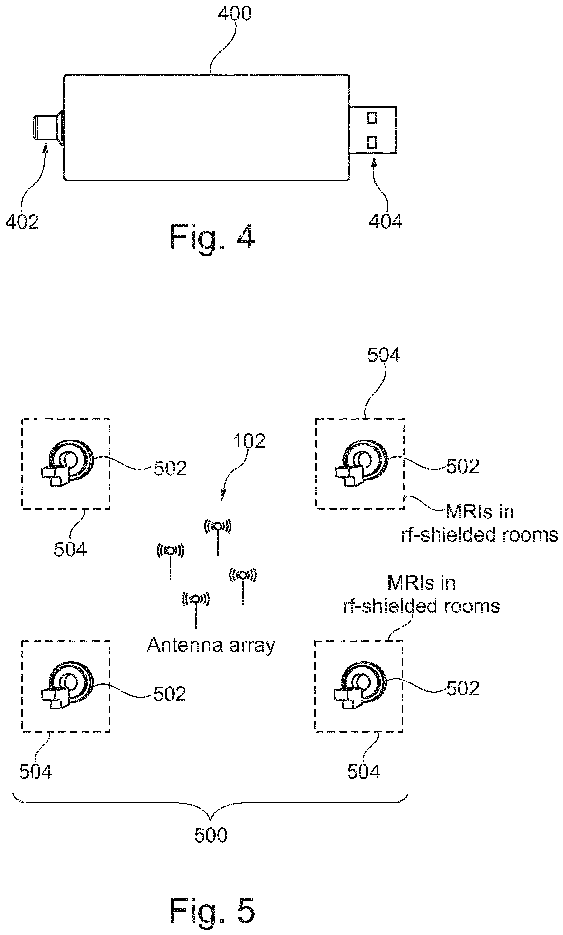

Fig. 4 shows an example of a software-defined radio 400 and at either end there is an RF connector 402 configured to connect to a transmission line from an antenna 102. On the other end there is a USB connector 404 which enables the software-defined radio 400 to be used by a computer.

By attaching a DVB-T antenna (optimized for much higher frequencies) to such a system (even without a low-noise preamplifier), we were able to receive the pulses radiated from an MRI system remotely (~20 meters) even through the RF-cage: The RF power generated by an MRI system is around - 10 dBm/Hz (10kW inside a quite narrow frequency band, significantly below 1 MHz already for a volume excitation and much less for a single slice). An inexpensive receiver without any optimization for a certain frequency has a noise figure of around 15dB. This defines the minimum input level compared to thermal noise (roughly -174dBm/Hz) to be -159 dBm/Hz which means the transmission from a body coil to the receiver antenna needs to be at least -149dB. The RF cage is typically attenuating by around 100 dB, thus the coupling of an unshielded body coil to antenna just needs just to be around -49dB. This proves the feasibility of examples, even with a badly matched antenna without optimized preamplifier and could easily monitor typical MRI systems from around 20m distance. Using an optimized antenna and preamplifier, the sensitivity can be improved by at least 14dB which means, the sensing distance can be increased by a factor 5, thus to around 100m.

With the cheap SDR receiver and some computer code, it was possible to detect not just start and end of an MRI procedure but also some characteristic numbers like amplitude, bandwidth, pulse length which can be used to distinguish between different scan types, especially 2D (mainly imaging) and 3D (mainly preparation) scans. Using a second antenna would allow to detect the direction of the signal to distinguish between different systems. However, even systems of different vendors at the same nominal B0-strength can be separated easily due to the slightly different real B0 (thus also central frequency) they use since this is vendor-dependent.

For this analysis, it is sufficient to sample just a short sequence. After optional filtering, we used a fast Fourier transform (FFT) to get the frequency-dependent signal curve. By some post-processing we derived central frequency, amplitude and bandwidth of the transmit RF pulses. As already mentioned, a more advanced embodiment can use two or more antennas and also evaluate the phase differences of the signals received. By that, the direction to the system can be derived. For calibration, each system can be driven while others are silent. However, also an automatic calibration, e.g. using machine learning (ML) or deep learning (DL) algorithms can be implemented.

In one example, the detection of MRI operation is performed according to the following method:
1. Define center frequency and bandwidth to look for (e.g., 64MHz for a 1.5T MRI system)
2. Measure frequency spectrum obtained from SDR
3. Compare RF power detected in a window around the defined center frequency with the RF power detected outside the window
4. If the ratio of power detected inside/outside window is above a pre-defined threshold, assume MRI is in operation. Otherwise, assume that MRI is not in operation.
5. Whenever the operation status changes from "not in operation" to "in operation", emit a message signaling the start of a scan
6. Whenever the operation status changes from "in operation" to "not in operation", emit a message signaling the end of a scan, optionally equipped with further scan procedure details derived from e.g. bandwidth, amplitude, number and frequency of pulses or other statistics
7. Repeat from 2.

If more than one MRI is present, a receiver system at a single location may be used to distinguish between the different MRI systems in one of the following ways:
1. If all MRI systems can be distinguished by center frequency, define several center frequencies and windows, one for each scanner. Proceed with the above method for all windows.
2. If two or more MRI scanners use the same center frequency but have different distance from the receiver, the absolute signal strength of the systems may be used to distinguish them. This may not always possible, since the signal strength may depend on the operation mode of the system and on the configuration of doors, windows, and equipment in the way between the systems and the receiver.
3. In the general case, an array of receiver antennas can be used to distinguish between the systems. In this case, the relative phase differences between the signals received at the different antennas can be used as identifier, possibly in combination with signal strengths. Such a setup is displayed in Fig. 5.

Fig. 5 illustrates a further example of a medical system 500. In this example the antenna 100 and other components of the medical system, as illustrated in Fig. 100, are present. There are a number of magnetic resonance imaging systems 502 which are located in radio-frequency shielded rooms 504. The radio-frequency shielded rooms 504 function as a radio-frequency shield 504. The array of antennas 102 is able to distinguish radio-frequency signals emitted from different MRI systems 502 using such things as differences in amplitude and phase.

In order to train the receiver system to recognize the signals emitted from different MR scanners using an antenna array, the following method can be used:
For each scanner, a relative phase difference and signal strength pattern is recorded while only this one scanner is in operation.

The set of vectors of phase differences is then used as a basis for the decomposition of received signal superposition. In this way, the relative contribution from each scanner to the received signals can be determined.

By making use of further information e.g. via log file analyses, a machine language algorithm can be trained to detect further sequence details.

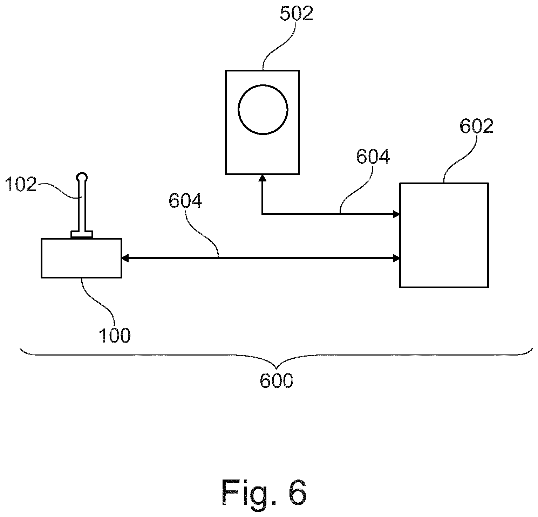

Fig. 6 illustrates a further example of a medical system 600. In this example there is the computer and antennas 102 as was illustrated in Fig. 1. The medical system 600 is shown as comprising at least one magnetic resonance imaging system 502. Both are connected to a remote-control system 602 via network connections 604. The antenna 102 and computer 100 are able to detect an operating state 122 of the magnetic resonance imaging system 502. This is communicated via the network connection 604 back to the remote-control system 602. The remote-control system 602 is then able to send commands via the network connection 604 to the magnetic resonance imaging system 502. This for example could be performed on the basis of the operating state 122 either by an operator or by an automated control system such as a software robot.

It is understood that one or more of the aforementioned examples of the invention may be combined as long as the combined examples are not mutually exclusive.

As will be appreciated by one skilled in the art, aspects of the present invention may be embodied as an apparatus, method, or computer program product. Accordingly, aspects of the present invention may take the form of an entirely hardware example, an entirely software example (including firmware, resident software, micro-code, etc.) or an example combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A `computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some examples, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

`Computer memory' or 'memory' is an example of a computer-readable storage medium. Computer memory is any memory which is directly accessible to a computational system. `Computer storage' or 'storage' is a further example of a computer-readable storage medium. Computer storage is any non-volatile computer-readable storage medium. In some examples computer storage may also be computer memory or vice versa.

A `computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to examples of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A `user interface' as used herein is an interface which allows a user or operator to interact with a computer or computer system. A `user interface' may also be referred to as a `human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A `hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or `display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,

Cathode ray tube (CRT), Storage tube, Bi-stable display, electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

Medical imaging data is defined herein as being recorded measurements made by a tomographic medical imaging system descriptive of a subject. The medical imaging data may be reconstructed into a medical image. A medical image id defined herein as being the reconstructed two- or three-dimensional visualization of anatomic data contained within the medical imaging data. This visualization can be performed using a computer.

K-space data is defined herein as being the recorded measurements of radio-frequency signals emitted by atomic spins using the antenna of a Magnetic resonance apparatus during a magnetic resonance imaging scan. Magnetic resonance data is an example of tomographic medical image data.

A Magnetic Resonance Imaging (MRI) image or MR image is defined herein as being the reconstructed two- or three-dimensional visualization of anatomic data contained within the magnetic resonance imaging data. This visualization can be performed using a computer.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### REFERENCE SIGNS LIST

- 100: medical system
- 102: antenna
- 104: computer
- 106: radio-frequency receiver
- 108: computational system
- 110: memory
- 112: network interface
- 114: machine executable instructions
- 116: radio-frequency data
- 118: optional radio-frequency parameter
- 120: optional database of pulse sequences
- 122: operating states
- 200: control the receiver to perform the transformation of the received radio-frequency transmissions into the radio-frequency data
- 202: determine one or more operating states of the at least one magnetic resonance imaging system using the radio-frequency data
- 204: transmit the one or more operating states via a network connection
- 300: frequency spectrum
- 302: dB
- 304: frequency
- 306: power
- 308: time (samples)
- 310: noise
- 312: band width
- 314: center frequecy measured
- 316: in-use status indicatator
- 400: software defined radio
- 402: RF connector
- 404: USB connector
- 500: medical system
- 502: magnetic resonance imging system
- 504: radio-frequency shield
- 600: medical system
- 602: remote-control system
- 604: network connection

## Claims

1. A medical system (100, 300, 500, 600) comprising, a magnetic resonance imaging monitoring device (100), wherein the magnetic resonance imaging monitoring device comprises:
- at least one antenna (102) configured for receiving radio-frequency transmissions from at least one magnetic resonance imaging system (502);
- a radio-frequency receiver (106) connected to the at least one antenna and configured for transforming the received radio-frequency transmissions into radio-frequency data (116);
- a memory (110) storing machine executable instructions (114); and
- a computational system (108), wherein execution of the machine executable instructions causes the computational system to continuously:
- control (200) the radio-frequency receiver to perform the transformation of the received radio-frequency transmissions into the radio-frequency data,
- determine (202) one or more operating states (122) of the at least one magnetic resonance imaging system using the radio-frequency data; and
- transmit (204) the one or more operating states via a network connection (604).

2. The medical system of claim 1, wherein the medical system further comprises the one or more magnetic resonance imaging systems.

3. The medical system of claim 2, wherein the one or more magnetic resonance imaging systems comprise a radio-frequency cage (504) wherein at least a portion of the at least one of antenna is located outside of the radio-frequency cage.

4. The medical system of claim 2 or 3, wherein at least one of the one or more magnetic resonance imaging systems comprises a radio-frequency component connected to a radio-frequency transmitter via a transmission line, wherein at least one of the at least one antenna is located within a predetermined distance to the radio-frequency component, wherein the radio-frequency data is descriptive of the operation of the radio-frequency transmitter, wherein the one or more operating states comprises an operational state of the radio-frequency transmitter.

5. The medical system of any one of the preceding claims, wherein the radio-frequency receiver is configured for measuring the radio-frequency data as one or more analog measurements.

6. The medical system of any one claims 1 through 4, wherein the radio-frequency receiver is configured for digitizing the received radio-frequency transmissions into the radio-frequency data;

7. The medical system of any one of the preceding claims, wherein execution of the machine executable instructions further causes the computational system to:
- determine a frequency spectrum (300) inside of a magnetic resonance system specific central frequency at a magnetic field isocenter of the at least one magnetic resonance imaging system; and
- determine defining an in-operation state or a not-in-operation state for the at least one magnetic resonance imaging system using the frequency spectrum inside of the magnetic resonance system specific central frequency (304), wherein the one or more operating states comprises the in-operation state and the not-in-operation state.

8. The medical system of any one of the preceding claims, wherein execution of the machine executable instructions further causes the computational system to:
- determine any one of the following: a radio-frequency amplitude, radio-frequency bandwidth, radio-frequency pulse duration, and combinations thereof using the radio-frequency data; and
- determine a pulse sequence protocol by comparing the any one of the following: the radio-frequency amplitude, radio-frequency bandwidth, radio-frequency pulse duration, and combinations thereof to a database of pulse sequences, wherein the one or more operating states comprises the pulse sequence protocol.

9. The medical system of claim 6, wherein execution of the machine executable instructions further causes the computational system to:
- detect a failure mode by comparing the any one of the following: the radio-frequency amplitude, radio-frequency bandwidth, radio-frequency pulse duration, and combinations thereof to the database of pulse sequences; and
- send a warning signal via the network connection if the failure mode is detected.

10. The medical system of any one of the preceding claims, wherein the at least one antenna is multiple antennas, wherein the radio-frequency data is acquired for the multiple antennas, wherein the radio-frequency data for the multiple antennas is phase and/or amplitude correlated, wherein execution of the machine executable instructions further causes the computational system to:
- determine a direction of the radio-frequency transmissions using the phase and/or amplitude correlation of the radio-frequency data;
- differentiate between the different at least one magnetic resonance imaging system using the direction of the radio-frequency transmissions; and
- modify the one or more operating states to indicate which of the at least one magnetic resonance imaging systems is operational using the direction of the radio-frequency transmissions.

11. The medical system of any one of the preceding claims, wherein the medical system further comprises a remote-control system (602) configured for simultaneously controlling the one or more magnetic resonance imaging systems, wherein the remote-control system is configured for receiving the one or more operating states via the network connection.

12. The medical system of claim 11, wherein the remote-control system is configured to:
- detect an early halt in a magnetic resonance imaging procedure in a detected magnetic resonance imaging system of the at least one magnetic resonance imaging system using the one or more operating states via a network connection; and
- send failure recovery control commands to the detected magnetic resonance imaging system in response to detecting the early halt.

13. The medical system of 11 or 12, wherein the remote-control system is configured to:
- generate scheduling data for at least one magnetic resonance imaging procedure using the at least one magnetic resonance imaging system using the one or more operating states; and
- control a timing of sending of control commands to the at least one magnetic resonance imaging system using the scheduling data.

14. A computer program comprising machine executable instructions (114) for execution by a computational system (108) controlling a magnetic resonance imaging monitoring device (100),
wherein the magnetic resonance imaging monitoring device comprises:
- at least one antenna (102) configured for receiving radio-frequency transmissions from at least one magnetic resonance imaging system (502); and
- a radio-frequency receiver (106) connected to the at least one antenna and configured for transforming the received radio-frequency transmissions into radio-frequency data (116);
wherein execution of the machine executable instructions causes the computational system to continuously:
- control (200) the receiver to perform the transformation of the received radio-frequency transmissions into the radio-frequency data,
- determine (202) one or more operating states (122) of the at least one magnetic resonance imaging system using the radio-frequency data; and
- transmit (204) the one or more operating states via a network connection.

15. A method of operating a medical system (100, 300, 500, 600), wherein the medical system comprises a magnetic resonance imaging monitoring device (100), wherein the magnetic resonance imaging monitoring device comprises:
- at least one antenna (102) configured for receiving radio-frequency transmissions from at least one magnetic resonance imaging system (502); and
- a radio-frequency receiver (106) connected to the at least one antenna and configured for transforming the received radio-frequency transmissions into radio-frequency data (116);
wherein the method comprises continuously:
- controlling (200) the receiver to perform the transformation of the received radio-frequency transmissions into the radio-frequency data,
- determining (202) one or more operating states (122) of the at least one magnetic resonance imaging system using the radio-frequency data; and
- transmitting (204) the one or more operating states via a network connection.
